Europäisches Patentamt

(19) European Patent Office

Office européen des brevets

(11) Publication number: **0 035 892**
A2

# (12) EUROPEAN PATENT APPLICATION

(21) Application number: **81300953.7**

(22) Date of filing: **06.03.81**

(51) Int. Cl.³: **G 05 D 7/06**
**H 03 K 17/94, F 16 K 31/02**

(30) Priority: **06.03.80 GB 8007652**

(43) Date of publication of application:
**16.09.81 Bulletin 81/37**

(84) Designated Contracting States:
**AT BE CH DE FR GB IT LI LU NL SE**

(71) Applicant: **HEATRAE-SADIA HEATING LIMITED**
**Hurricane Way**
**Norwich(GB)**

(72) Inventor: **Purser, Derrick Gilbert George**
**Ivy House Necton**
**Swaffham Norfolk(GB)**

(72) Inventor: **Blake, Roger Alan**
**11A Abbey Road**
**Watton, Norfolk(GB)**

(74) Representative: **Burrows, Anthony Gregory et al,**
**Haseltine Lake & Co. Hazlitt House 28 Southampton**
**Buildings Chancery Lane**
**London, WC2 1AT(GB)**

(54) Fluid flow control.

(57) One or more manually operable proximity switches (34, 35) control electrically valve means (30, 33) consisting of either a variable flow valve which is also a shut-off valve, or a variable flow valve (30) and a separate shut-off valve (33), in a water supply line. The valve means (30, 33) can be a water tap or in a water input line of a water heater. Two proximity switches (34, 35) can be provided, one (34) to increase and the other (35) to decrease the throughflow cross-section of the valve means (30, 33). The time period for which each switch (34, 35) is operated determines the degree of change of the cross-section.

EP 0 035 892 A2

./...

Croydon Printing Company Ltd.

Fig.7.

-1-

## FLUID FLOW CONTROL

This invention relates to fluid flow control, particularly by means of a fluid flow control valve, for example a water tap or a valve in a water input line of a water heater.

British Patent 1158311 discloses a fluid flow control valve in which a movable valve member, in the form of a ball or a poppet of magnetic material, is arranged in a valve chamber between two valve seats in a duct. Two annular electromagnet solenoids for producing respective magnetic fields in the regions of the seats encircle the duct beyond the ends of the valve chamber. By operating one or the other or both of the solenoids, the valve member can be made to travel towards one or the other of the seats, thereby increasing the pressure drop produced by that seat. Permanent magnets movable into or out of the vicinities of the respective seats can be provided instead of the solenoids. The valve constitutes a very simple electromagnetic, pressure-producing switch or transducer in which the valve member is the only movable part. The valve member is normally never in contact with either of the seats when the valve is in use. The fluid may be either a liquid, e.g. pressurized oil, or a gas, e.g. compressed air. This valve is not suitable for use as a water tap or in a water supply line of a water heater since it is not designed to act as a shut-off valve.

Various systems are known involving automatic opening of a valve following a user's hand being brought within range of (including being brought into contact with) a detector and automatic closing of the valve following the user's hand being taken out of range of the detector. They can be photoelectric systems, variable capacitance systems, ultrasonic systems, or high frequency loss systems.

United States Patent 3,588,038 discloses such a system based on the high frequency loss principle and for use in relation to a water basin or a wash basin.

British Patent 1202663 discloses a system in which a high frequency signal is supplied to at least one proximity detector mounted on a water outlet pipe and operating as a voltage divider of which the output voltage may be influenced by putting the hand near the proximity detector, the output voltage controlling an associated electromagnetic valve. The detector(s) are mounted near to the outlet end of the outlet pipe, which can be over a wash basin, and face(s) the user.

Federal German Offenlegungsschrift 2136318 discloses another such system which operates on the photoelectric principle.

Federal German Offenlegungsschrift 2218833 discloses a system in which at least one water tap is operated by a change-of-state signal from a quartz oscillator the state of which is dependent on a capacitive sensor associated with the tap.

Federal German Offenlegungsschrift 2629794 discloses such a system, in which a washbasin mixer for hot and cold water is actuated by capacitive means. The capacitive means includes an antenna for connecting in a capacitive manner two solenoid valves inserted in respective hot and cold water ducts of the mixer. The antenna comprises a metal layer on the top, rear and two sides of the external surface of an electrically insulating hood of the mixer, the antenna being electrically connected to an electronic switching device in the hood. Variable flow rotary valves which are manually rotated are also inserted in the respective hot and cold water ducts.

In all of these systems, the or each electrically operated valve occupies either its fully closed position or its fully open position. Where variable fluid output rates are required, these are obtained in the last-mentioned system by manual rotation of the variable flow rotary valves. Therefore the disadvantage arises that the user either is unable to adjust the flow rate or has to remove at least one hand from within range of the detector, in order to rotate a rotary valve.

Federal German Offenlegungsschrift 2734470 discloses an electronic power regulator for electric cooking devices, particularly electric hotplates, comprising an input device containing "touch" switches for manual upward and downward adjustment of a counter. The switches are associated with an illuminated line containing illuminated diodes. An electronic temperature regulating device is adjustable by the counter and varies the relative duration of voltage application. The regulator also comprises a temperature sensor exposed to the temperature of the cooking device and arranged to influence the temperature regulating device in order to change the relative duration of voltage application. This apparatus is not applied to water flow control.

According to one aspect of the present invention, there is provided fluid flow control apparatus, comprising fluid flow control valve means, valve obturating means of said valve means, and manually operable electrical means arranged to operate said valve obturating means, characterised in that said valve means and said electrical means are so constructed that said valve obturating means can act both to shut off fluid flow through said valve means and to adjust the rate of fluid flow therethrough and maintain the adjusted rate.

This apparatus has the advantages that the electrical means is used both to shut off the fluid flow and to enable the operator to adjust the fluid flow.

According to another aspect of the present invention, there is provided apparatus comprising duct means for fluid flow, a valve arranged in said duct means for controlling said fluid flow, and first and second manually operable control means arranged to control valve means, characterised in that manual operation of the first control means serves to increase the throughflow cross-section of said valve and that manual operation of the second control means serves to reduce said throughflow cross-section.

With this apparatus, the operator has the advantage of having two distinct control means for fluid flow increase and fluid flow decrease.

According to a further aspect of the present invention, there is provided apparatus comprising duct means for fluid flow, valve means arranged in said duct means for controlling said fluid flow, and manually operable electrical control means arranged to control said valve means, characterised in that manual operation of the control means serves to change the throughflow cross-section of said valve means, the degree of said change being dependent upon the period of time throughout which the operator remains continuously in operating condition relative to said control means.

With this apparatus, the operator has the advantage of a straightforward mode of adjusting the fluid flow to his requirements.

According to a yet further aspect of the present invention, there is provided fluid flow control apparatus, comprising fluid flow control valve means, manually operable electrical means arranged to operate said valve means, and electrical mains supply means electrically connected to said electrical means, characterised in that electrical energy storage means is arranged to supply automatically said electrical means in the event of a cessation of supply by said mains supply means.

Owing to the provision of the electrical energy storage means, the valve means is still operable even in the event of a mains failure.

The apparatus of the present invention can advantageously include an isolating step-down transformer for connection to mains supply and whose output side is arranged to feed a low-voltage supply circuit for the flow control valve means, and an energy storage unit which is arranged to be charged by the supply unit but also to maintain supply for operating the flow control valve means in the event of mains supply failure.

The manually operable electrical means in one preferred arrangement includes, on the outside of an outlet spout, a sensitive region which is responsive to close proximity of the operator's hand to provide a command signal for controlling operation of the flow control valve means. In a modification a manually operable element (such as a mechanically operable switch) is provided in place of the sensitive region. In both cases, response of the sensitive region or the manually operable element can be arranged to operate a low-voltage circuit for controlling operation of the flow control valve means. In place of the low-voltage circuit, a transmitter-receiver link (e.g. ultrasonic) can be used.

For a better understanding of the invention and to show how the same may be carried into effect, reference will now be made, by way of example, to the accompanying drawings, in which:-

Figure 1 is a first embodiment of a water heating system,

Figure 2 shows a modification,

Figure 3 indicates how the Figures 1 and 2 embodiments could be modified so as to incorporate a controlled-flow cold water supply,

Figure 4 is a vertical section view, diagrammatically showing one form of proportional-flow control valve,

Figure 5 shows in a corresponding view another form of proportional-flow valve,

Figure 6 is a diagrammatic, vertical sectional view through a discharge spout incorporating a proximity switch for controlling flow through the spout,

Figure 7 shows diagrammatically a rotary water tap apparatus, and

Figure 8 shows diagrammatically a linear water tap apparatus.

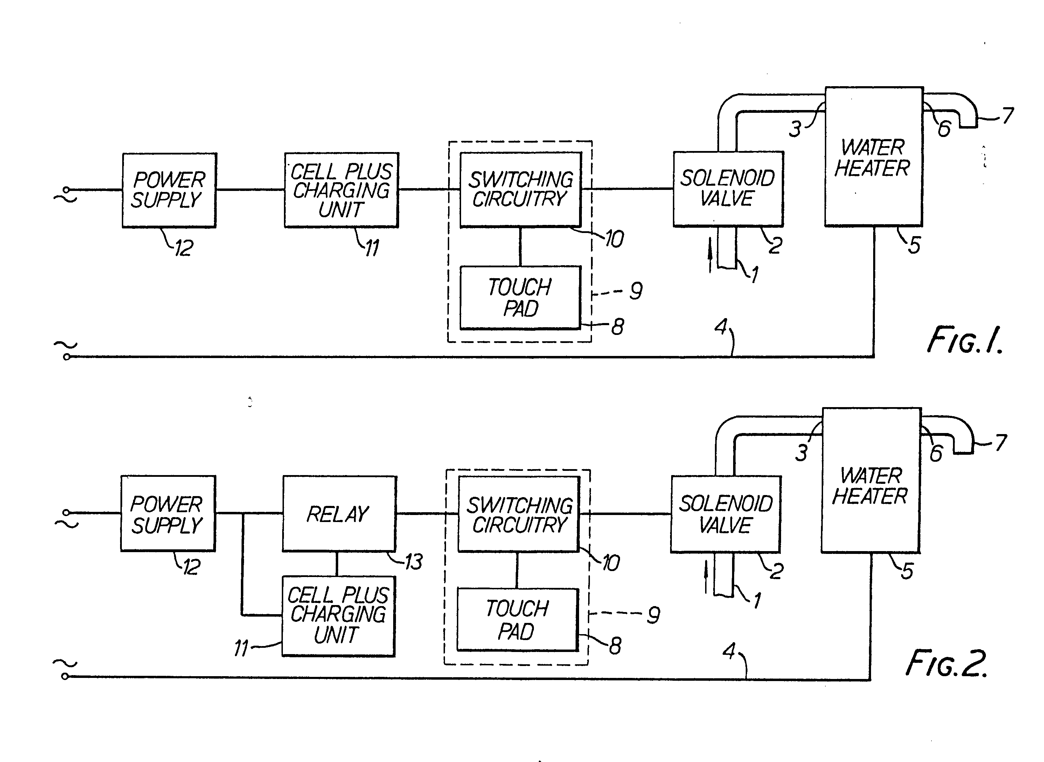

Referring to Figure 1, cold water is fed along a supply pipe 1 to a variable flow solenoid valve 2 which when open allows cold water to flow into the inlet 3 of an electrical water heater 5 whose heating element is supplied from an electrical supply line 4 and is thermostatically controlled. Water heated in the heater 5 passes through the heater outlet 6 and a discharge spout 7 into a basin or bath. The solenoid valve 2 is opened by the operator moving his hand into close contact or touching contact with the touch pad 8 of a proximity switch 9 so as to operate the switching circuitry 10 of the switch 9 to control the flow of energising current from the cell of a combined cell-charging unit 11 to the energisation coil of the valve 2. The valve 2 remains open until the operator returns his hand into close or touching contact with the pad 8, whereupon the solenoid valve 2 closes again. The charging unit of the combined unit 11 is fed from a power supply unit 12 which consists of an isolating step-down transformer fed from the mains, and a bridge rectifier, with smoothing circuit, connected to the low voltage side of the transformer to give a low voltage direct-current supply for charging the cell of the combined unit 11. In the event of failure of the electrical power supply, although the water heater 5 will be unable to heat water passing through it, the solenoid valve 2 can still be operated from a proximity switch 9 because the cell in the combined unit 11 acts as a standby for supplying the required energising current to the solenoid valve 2. Because the step-down transformer in the power unit 12 is an isolating transformer there is no risk of impairment of electrical safety even in the event of any short-circuiting between the low-voltage power supply circuit to the solenoid valve and the water in that valve.

In the modification of Figure 2, the output side of the combined unit 11 is connected to the energisation coil of a relay 13 connected between the power supply unit 12 and switching circuitry 10 such that providing mains supply to the power supply unit 12 is maintained the output side of the power unit is connected through the relay to the input side of the switching circuitry 10. In the event of mains supply failure, the relay trips so as to break the connection between the power supply unit 12 and the switching circuitry 10 but to make a fresh connection between the output side of the combined unit 11 and the input side of the switching circuitry 10, thereby providing stand-by power supply to the switching circuitry.

In order to provide infinitely adjustable flow control, the switching circuitry 10 provides proportional control of the solenoid valve depending upon the length of time for which an operating signal is supplied by the touch pad 8, in other words for which an operator continuously operates the touch pad 8.

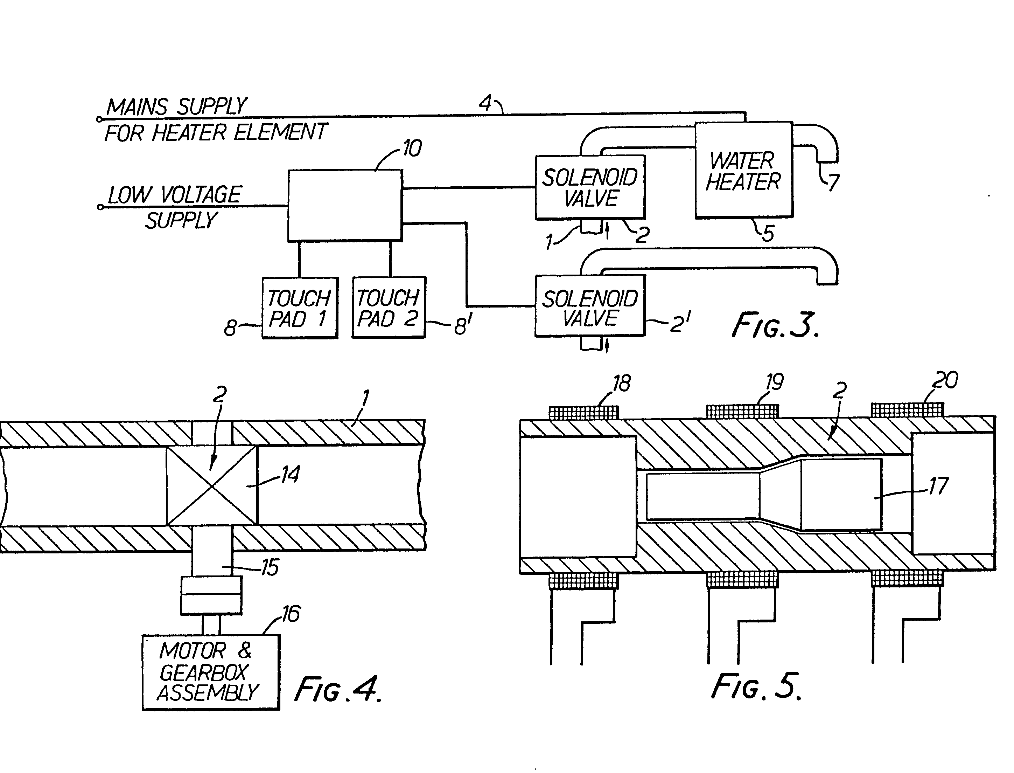

Figure 3 illustrates a modification to the Figure 1 or Figure 2 arrangement, so as to allow for individual control of hot and cold water supply facilities at the basin. Thus, the proximity switch includes two touch pads 8, 8', respectively for controlling the hot and cold water supplies and the switching unit 10 consists of dual switching circuitry for controlling operations of the hot-and cold-flow solenoid valves 2, 2', respectively.

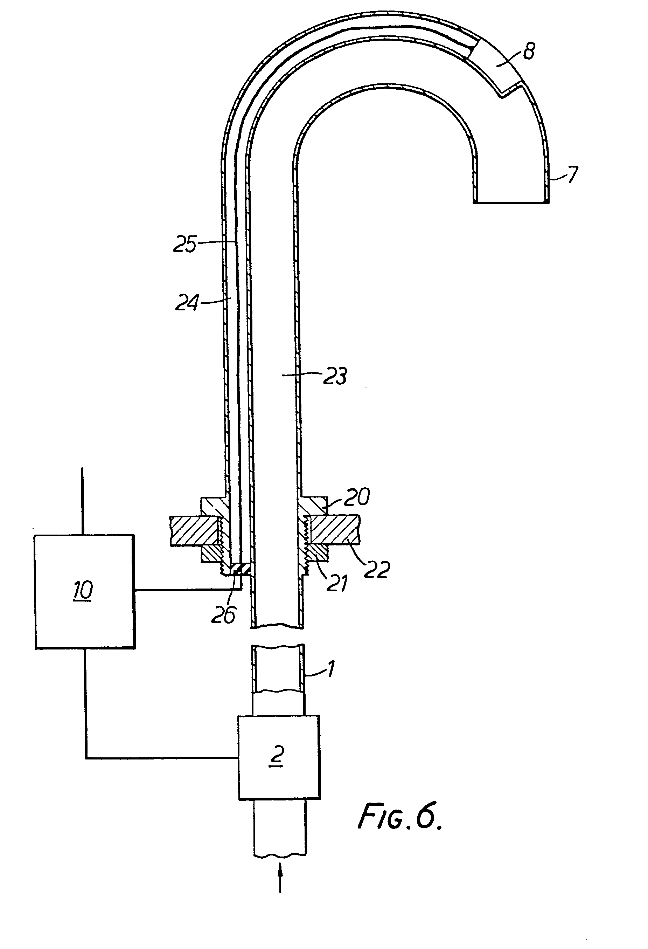

Figures 4 and 5 show two different possible forms of construction of variable-flow valve which can be used in place of the variable-flow solenoid valve. In the rotary valve shown in Figure 4, a flap 14 in the flow passage within the supply line 1 is rotatably mounted on a shaft 15 driven by a motor and gear box assembly 16 supplied from the switching circuitry of the proximity switch and can thereby be rotated into any desired position between a transversely orientated position in which the flap completely closes-off the flow passage

-8-

in the supply pipe 1 and the illustrated fully-open position in which the plane of the flap is aligned with the flow passage through the pipe. In Figure 5, the axial position of the conical taper member 17 is adjusted by the differential transformer principle using, in this example, three energisation coils 18, 19 and 20.

In the different embodiments indicated in Figures 1 to 5 it will be appreciated that even in the event of any short-circuit brought about by contact between water and any part of the low-voltage electrical control circuitry no impairment of electrical safety will occur because the circuitry is isolated, by the isolating transformer, from the mains.

Figure 6 shows diagrammatically a practical form for a flow control assembly for controlling flow of water into the basin. The illustrated arrangement is suitable for both hot and cold water supply although in the latter case the water heater is positioned between the solenoid valve 2 and the discharge spout 7. In this constructional example, the spout 7 is clamped to the ledge 22 of the basin by means of a sealing collar 20 on the upstanding stem of the spout near the base of the spout and also a clamping nut 21 engaged with an external screw-thread formed around the base of the upstanding stem of the spout. At the top, the stem is curved forwardly and then downwardly for discharging water into the basin. Positioned in the wall of the spout so as to be accessible from the outside and face generally towards the operator is the touch pad 8. The spout 7 is divided internally to provide a water conveying passage 23 and a further passage 24 through which extends a connecting lead 25 which connects the touch pad 8 to the control input of the switching circuitry 10. A plug 26 completely seals off the passage 24. Ordinarily no water can enter the passage 24 and even if it did the insulation on the connecting lead 25 would prevent water coming into contact with the core of the connecting lead 25. However, even if such contact were under very unusual circumstances to occur, there would be no impairment of electrical safety as the low voltage circuitry controlling the operation of the solenoid valve 2 is isolated from the mains supply.

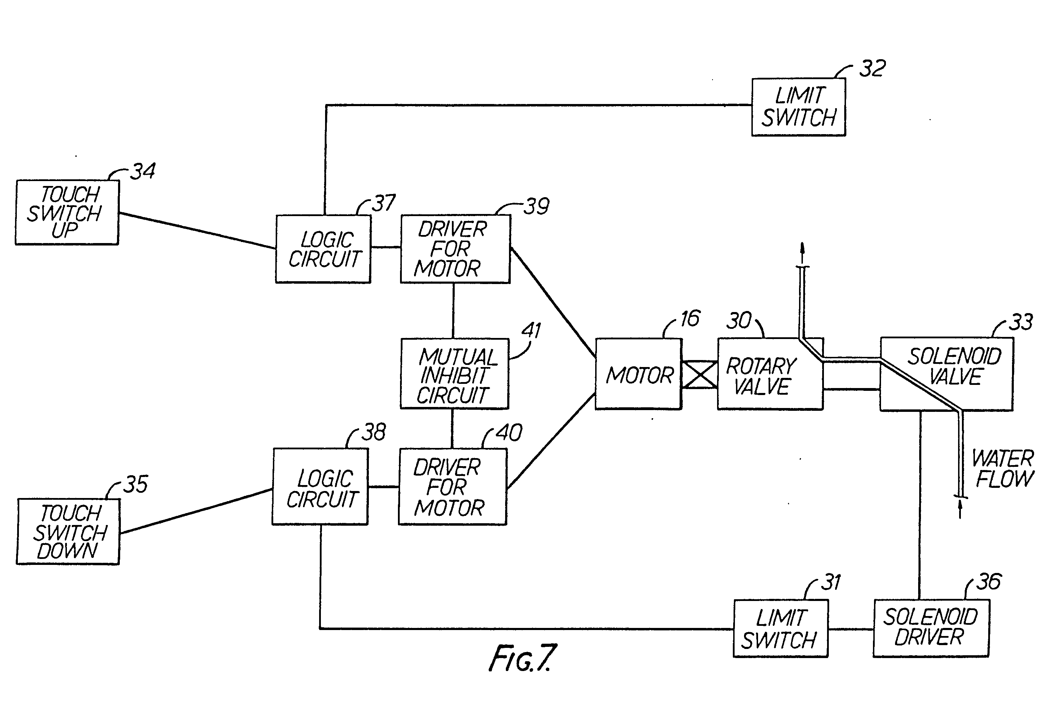

The apparatus of Figure 7 is a development combining ideas shown in Figures 3, 4 and 6. A rotary valve 30 according to Figure 4 has its rotary obturating member capable of at least $180^{\circ}$ of movement. The valve 30 is driven by a motor and gearbox assembly 16 which is reversible, one direction giving an increase in flow, the other giving a decrease in flow. To ensure accurate movement of the valve obturating member, there are two limit switches 31 and 32, of which switch 32 is actuated in the maximum position to prevent movement of the valve obturating member beyond that position, and the switch 31 is actuated in the minimum flow position to prevent movement of the valve obturating member beyond that position. An on-off solenoid valve 33 is connected in series with the rotary valve 30, with respect to water flow, to prevent the flow of water when the system is in the off mode, because the valve 30 allows a trickle of water when in its minimum flow condition. Manual control by the operator is by two touch switches 34 and 35 of which 34 is for 'on' and increase of flow and 35 is for decrease and 'off'. The touch switches 34 and 35 and the limit switches 32 and 31 are connected to respective logic circuits 37 and 38 which operate the motor 16 by way of respective driver circuits 39 and 40. Provided that the corresponding limit switch 31 or 32 is open, the touch switch 35 or 34, when 'touched', will cause a change in flow. The amount of change will depend upon the time period for which the operator is in continuous 'touch' with the switch. The minimum flow limit switch 31 also operates the solenoid valve 33 <u>via</u> a suitable driver circuit 36. The solenoid valve 33 is always open except when the valve 30 is in the minimum flow position. When the valve 30 is in this position the limit switch 31 will operate to cause closing of the solenoid valve 33. Built in the circuitry is an inhibit circuit 41 and its function is such that the motor 16 is not energised by both driver circuits at the same time. Therefore, if both touch switches are touched at the same time, only the first one touched will have any effect. A mains power failure will always switch off the solenoid valve 33 and stop the water flow. This power failure effect can if desired be overcome by an automatically set back-up electrical supply, as hereinbefore.

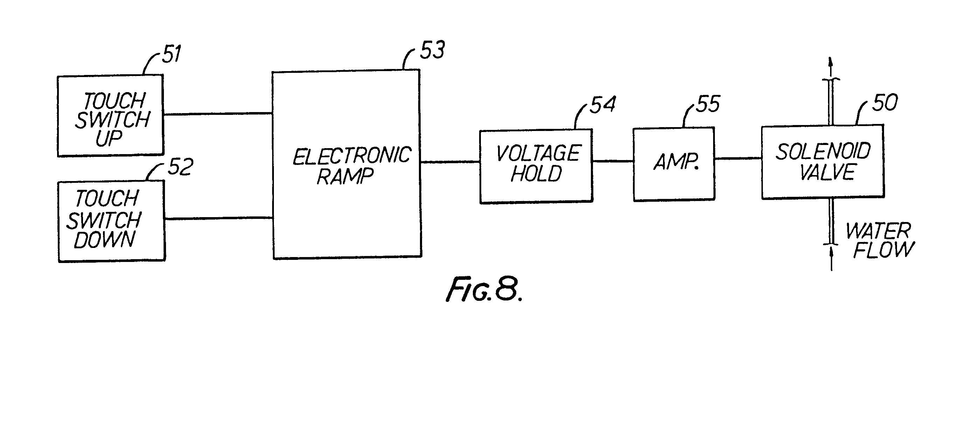

Referring to Figure 8, the apparatus shown comprises a solenoid-driven water tap 50. The tap is a linear motion device in that the flow therethrough is governed by the linear position of the valve closure member of the tap. Movement : of the member is achieved by a proportional solenoid (which has a linear relationship between the magnitude of its current and its force output) acting against the spring. A touch switch 51 for 'on' and flow increase and a touch switch 52 for flow decrease and 'off' control the tap 50 through an electronic ramp circuit 53, a voltage hold circuit 54 and an amplifier 55. The degree of flow increase or decrease is again determined by the time period of continuous 'touching' of the switch 51 or 52.

The apparatus is fail safe in that loss of power from the amplifier 55 de-energises the solenoid which will return the valve closure member through the minimum flow position to the off position. Touching of one of the touch switches initiates a ramp signal which limits the rate of rise or fall in the voltage applied to the solenoid. The voltage hold circuit 54 retains the existing voltage level when operator contact with the touch switch ceases. Thus the flow through the valve closure member is retained at that level until one of the touch switches is actuated to change the condition either up or down.

A further control can be added, such that actuation of both touch switches or a third touch switch will shut the flow off automatically by closing the valve closure member at a pre-determined rate.

<u>CLAIMS</u>

1. Fluid flow control apparatus, comprising fluid flow control valve means (2; 30, 33; 50), valve obturating means (14;17) of said valve means (2;30,33;50), and manually operable electrical means (8-10;31,32,34-41;51-55) arranged to operate said valve obturating means (14,17), characterised in that said valve means (2;30,33;50) and said electrical means (8-10;31,32,34-41;51-55) are so constructed that said valve obturating means (14;17) can act both to shut off fluid flow through said valve means (2;30,33;50) and to adjust the rate of fluid flow therethrough and maintain the adjusted rate.

2. Apparatus according to claim 1, characterised in that said valve means (2) is arranged in a water input line (1) of a water heater (5).

3. Apparatus according to claim 1 or 2, wherein said electrical means (8-10;31,32,34-41;51-55) comprises first and second manually operable control means (8,8'; 34,35; 51,52), characterised in that manual operation of the first control means (8;34;51) serves to increase the throughflow cross-section of said valve means (2;30,33;50) and that manual operation of the second control means (8'; 35;52) serves to reduce said throughflow cross-section.

4. Apparatus according to claim 3, characterised in that said electrical means (8-10;31,32,34-41;51-55)further comprises inhibiting means (41) arranged to prevent said first control means (34) and said second control means (35) from being effective simultaneously with each other.

5. Apparatus according to any preceding claim, characterised in that the degree of change of the throughflow cross-section of said valve means (2;30,33;50) on manual operation of said electrical means (8-10;31,32,34-41;51-55) is dependent upon the period of time throughout which the operator remains continuously in operating condition relative to said electrical means (8-10; 31,32,34-41; 51-55).

6. Apparatus according to any preceding claim, characterised in that said valve obturating means (14;17) cannot be displaced beyond a position corresponding to a pre-set
maximum.

7.  Apparatus according to claim 6, characterised
in that said electrical means (31,32,34-41; 51-55)
further comprises a limit switch (31) or  an electronic
ramp circuit (53) setting said maximum.

8.  Apparatus comprising duct means (1) for fluid
flow, a valve (2;30;50) arranged in said duct means
(1) for controlling said fluid flow, and first and
second manually operable control means (8,8'; 34,35;51,52)
arranged to control said valve, characterised in that manual operation of the first control means (8;34;51) serves
to increase the throughflow cross-section of said valve
(2;30;50) and that manual operation of the second
control means (8';35;52) serves to reduce said throughflow
cross-section.

9.  Apparatus according to claim 8, characterised in
that manual operation of each control means (8,8'; 34,35;
51,52) serves to change the throughflow cross-section
of said valve means(2;30;50) to a degree dependent upon the period
of time throughout which the operator remains continuously
in operating condition relative to that control means
(8,8'; 34,35; 51,52).

10.  Apparatus comprising duct means (1) for fluid
flow, valve means (2;30;50) arranged in said duct means
(1) for controlling said fluid flow, and manually operable
electrical control means (8,8'; 34,35;51,52) arranged
to control said valve means (2;30;50), characterised
in that manual operation of the control means (8,8';
34,35;51,52) serves to change the throughflow cross-section
of said valve means (2;30;50), the degree of said change
being dependent upon the period of time throughout which
the operator remains continuously in operating condition
relative to said control means (8,8'; 34,35;51,52).

11.  Fluid flow control apparatus, comprising fluid flow
control valve means (2), manually operable electrical
means (9) arranged to operate said valve means (2), and electrical mains supply means (12) electrically connected to said
electrical means (9), characterised in that electrical energy storage means (11) is arranged to supply automatically said electrical means (9) in the event of a cessation of supply by said mains supply means (12).

12.    Apparatus according to claim 11, wherein said storage means (11) is arranged to be charged by said electrical mains supply means (12).

FIG.1.

FIG.2.

MAINS SUPPLY 4
FOR HEATER ELEMENT

LOW VOLTAGE
SUPPLY

10

| SOLENOID VALVE | WATER HEATER |

1   2   5   7

TOUCH PAD 1   TOUCH PAD 2

8   8'

SOLENOID VALVE   2'

**FIG. 3.**

2   1

14

15

MOTOR &
GEARBOX
ASSEMBLY

16

**FIG. 4.**

18   19   2   20

17

**FIG. 5.**

FIG.6.

Fig.7.

FIG.8.